# EUROPEAN PATENT SPECIFICATION

(11) **EP 4 210 185 B1**
(45) Date of publication and mention of the grant of the patent: **22.10.2025**
(21) Application number: 22305017.0
(22) Date of filing: 10.01.2022
(51) Int. Cl.: H01S 5/026, H01S 5/50, H01S 5/0234, H01S 5/042, H01S 5/22, H01S 5/227, H01S 5/028

(54) **INTEGRATED OPTO-ELECTRONIC DEVICE FOR FLIP-CHIP INTEGRATION**
INTEGRIERTE OPTOELEKTRONISCHE VORRICHTUNG ZUR FLIP-CHIP-INTEGRATION
DISPOSITIF OPTO-ÉLECTRONIQUE INTÉGRÉ POUR L'INTÉGRATION DE BILLES

(43) Date of publication of application: 12.07.2023
(73) Proprietor: Nokia Solutions and Networks Oy, 02610 Espoo (FI)
(72) Inventor: GARREAU, Alexandre, 92160 ANTONY (FR); PARET, Jean François, 91290 ARPAJON (FR); CAILLAUD, Christophe, 94110 ARCUEIL (FR)
(74) Representative: Novagraaf Technologies

(56) References cited:
- US-A- 4 954 786
- US-A1- 2005 025 414
- US-A1- 2005 259 708
- US-A1- 2021 066 537
- MASON B ET AL: "Photonic integrated receiver for 40 Gbit/s transmission", ELECTRONICS LETTERS, THE INSTITUTION OF ENGINEERING AND TECHNOLOGY, GB, vol. 38, no. 20, 26 September 2002 (2002-09-26), pages 1196 - 1197, XP006018867, ISSN: 0013-5194, DOI: 10.1049/EL:20020778

## Description

### TECHNICAL FIELD

Various example embodiments relate to optoelectronic devices such as SOA-PIN integrated optoelectronic device. In particular, embodiments of the invention relate to the realization of such optoelectronic devices which is based on a one-step process of a Semi-insulated Buried Heterostructure (usually known by the acronym SiBH).

### BACKGROUND

As known by those skilled in the art, a SOA-PIN is a PIN photodiode (for Positive Intrinsic Negative photodiode) with p-type semiconductor region, intrinsic region and n-type semiconductor region integrated with a semiconductor optical amplifier (SOA) in a single chip. It is used to high frequency (up to 100Gbit/s) and long-distance transmission (10-100km) telecom applications. The SOA section operates under a continuous wave condition and input high frequency optical signals are detected by the PIN section to generate electrical output signals. The frequency response of an SOA-PIN depends on a capacitance in the PIN section. The chosen technology is generally based on ridge design with a passivation of the vertical sides by SiO₂ or Si₃N₄ dielectrics or resins.

The main drawback of the last solution is the difficulty of patterning the PIN. Indeed, the smaller the diode is, the higher frequencies are reachable.

It is thus interesting to choose the technology based on the Semi-Insulating Buried Heterostructure (SIBH) realized in one-step, as taught by the published European patent application EP 3416252A1.

However, the technology taught by EP 3416252A1 presents some drawbacks. Notably, the optoelectronic device with SiBH obtained by this technology is not flat, especially around the waveguide, because of the different growths of the [100] [110] or [111] crystallographic planes. Moreover, the metal contacts are not at the same level. It imposes to generate pillars for the via contact on the device or on the flip chip package. The no planarity of the device produces mechanical weakness. To avoid the last point, the general solution is to encapsulate the device in a resin R, but it generates a thermal resistivity. A bad heat evacuation strongly penalizes the performances of the chip.

Thus, in light of the foregoing, there is a need of an opto-electronic device wherein a SOA and PIN are integrated on the same semi-insulating wafer in order to reach high frequency, and wherein the manufacture of such a device is based on a one-step process of making a semi-insulating buried heterostructure (SIBH) where the p and n contacts are at the same level on the same wafer face and can be easily soldered to the package of the flip-chip package.

Reference is furthermore made to the following prior art documents disclosing integrated optoelectronic devices including a SOA and PIN :
- US 2005/025414 A1 (KAMIYAMA) 3 February 2005;
- US 2005/259708 A1 (PARK) 24 November 2005;
- US 4 954 786 A (YAMAKAWA) 4 September 1990;
- US 2021/066537 A1 (YU) 4 March 2021;
- MASON B ET AL: "Photonic integrated receiver for 40 Gbit/s transmission", ELECTRONICS LETTERS,vol. 38, no. 20, 26 September 2002, pages 1196-1197, DOI: 10.1049/EL:20020778

### SUMMARY

The invention is disclosed in the independent appending claims. Preferred embodiments are disclosed in the dependent claims.

Example embodiments of the invention aim to remedy all or some of the disadvantages of the above identified prior art.

The embodiments and features, if any, described in this specification that do not fall under the scope of the independent claims are to be interpreted as examples useful for understanding various embodiments of the invention.

A general embodiment relates to an integrated optoelectronic device D comprising:
- a substrate comprising at least a III-V semiconductor material (such as n-InP or semi-insulating InP),
   ▪ a layer of n-doped III-V semi-conductor (such as n-InP) disposed on said substrate, said layer of n-doped III-V semi-conductor presenting a base and two side walls;
   ▪ within a first zone along a longitudinal axis XX of the integrated optoelectronic device:
      ∘ a first central stripe portion comprising a buried optical waveguide Semiconductor Optical Amplifier (usually referred to as optical waveguide SOA),
      ∘ a first pair of longitudinal channels each located along each side wall on both sides of the first central stripe portion,
      ∘ said first zone constituting the SOA zone, and the remaining zone constituting a second zone;
   ▪ within said second zone along said longitudinal axis XX:
      ∘ a PIN zone comprising
         ▪ a second central stripe portion comprising a buried optical waveguide PIN, said optical waveguide PIN being in line with the optical waveguide SOA along the longitudinal axis XX and at the same level from the base,
         • a second pair of longitudinal channels each located along each side wall on both sides of the second central stripe portion,
      ∘ an intersectional zone located between the SOA zone and the PIN zone,
      ∘ an end zone located at the end of the PIN zone opposite to the SOA zone,
   ▪ metal stripes covering the top of the side walls and metal stripes covering respectively the top of the first and second central stripe portions,
   ▪ an electrical separation between the PIN zone and the SOA zones.

The device of the general embodiment presents the following advantages:
- the dimensions of the PIN can be decreased in order to reach high frequency without technological limit,
- suppression of the mechanical weakness,
- minimizing the wire bonding thus permitting to limit the Joule effect due to the current intensity and also parasitic capacitance or inductance limiting the optical high speed data transmission,
- easy evacuation of the heat produced by the photon generation in the laser and the photon modulation in the EAM because of the no presence of resin generating a thermal resistivity, and
- the heat produced by the photon generation in the laser and the photon modulation in the SOA-PIN can be easily evacuate because of the no presence of resin generating a thermal resistivity.

According to a first embodiment, the second central stripe portion may have a width w_{S2} comprised between 1,5 µm and 4 µm.

According to a second embodiment, the second central stripe portion may have a narrower width w_{S2}, that is 0, 5 µm and 2 µm, thus the optical guide is also narrow (presenting the same width) . It is particularly interesting to define a narrow optical guide in the PIN zone in order to limit the capacitance of the PIN.

Advantageously, within the first zone, the longitudinal channels may be each filled by a regrown semi-insulating stack from the base up to the level of the top of the layer of p-doped III-V semi-conductor material.

The optical waveguides of the SOA and of the PIN zones contains Multi Quantum Wells (usually referred to as MQWs) or quantum dots. The structure of Multi Quantum Wells is an alternatively stack of wells and barriers composed of AlGaInAs or GaInAsP semiconductors. Quantum Dots based on AlGaInAs or GaInAs semiconductors are also an interesting solution for the optical waveguides of the SOA and of the PIN zones.

Advantageously, within the first zone, the buried optical waveguide Semiconductor Optical Amplifier (referred to as SOA) may comprise at least Multi Quantum Wells (for instance based on GaInAsP or AlGaInAs) coated by a layer of p-doped III-V semi-conductor material comprising at least a p-InP layer and a p-doped III-V SC contact layer (such as p-GaInAs) at least up to the top of the side walls. MQWs of the SOA zone are embedded in a Separate Confinement Heterostucture, based of AlGaInAs or GaInAsP semiconductors for a better current injection.

Advantageously, within the PIN zone, the buried optical waveguide PIN of the second central stripe portion may comprise Multi Quantum Wells or Quantum Dots coated by a layer of p-doped III-V semi-conductor material comprising at least a p-InP layer and a p-doped III-V SC contact layer (such as p-GaInAs) at least up to the top of the side walls. MQWs of PINs are embedded in Separate Confinement Heterostucture.

According to the invention as claimed, within the PIN zone, the longitudinal channels C3, C4 are each filled by a regrown semi-insulating stack up to the top of the layer of p-doped III-V semi-conductor.

Advantageously, the intersectional zone may be filled by the regrown semi-insulating stack from the base up to the top of the layer of p-doped III-V semi-conductor.

Advantageously, the end zone may be filled by the regrown semi-insulating stack from the base up to the level of the top of the layer of p-doped III-V semi-conductor.

Advantageously, the metal stripe covering the second stripe portion also extends over the semi-insulating stack of the end zone.

Advantageously, the metal stripe covering the second stripe portion and extending over the semi-insulating stack of the end zone (IIc) may have the form of a trapeze. It is interesting to deposit a large contact for the PIN on the end zone in order to make the soldering of the contact on the flip-chip package easier. However, the metal contact width must stays on the p-semiconductor and the semi insulating InP to avoid an electric short cut between the p and n semiconductors. The high frequency capacitance is only limited by the width of the p-semiconductor.

Advantageously, the electrical separation between the PIN zone and the SOA zones may consists in a ribbon of implanted H+ located in the intersectional zone between the side walls perpendicular to longitudinal axis XX

Embodiments further provide a method of fabricating an integrated optoelectronic device (D), said method comprising:
A. providing a substrate (1) made of III-V semiconductor material (such as n-InP or semi-insulating InP) with a longitudinal axis XX:
B. performing an epitaxial growth of a layer of n-doped III-V semi-conductor on the substrate;
C. selectively etching said layer of n-doped III-V semi-conductor down to the level of said substrate to form a first groove with a U-shaped cross section of width W and thus to define a base and side walls;
D. performing an epitaxial growth of a layer of n-doped III-V semi-conductor and a first active material stack to fill the first groove on the layer of the regrown n-doped III-V semi-conductor;
E. performing an epitaxial growth of a layer of p-doped III-V semi-conductor material to fill said first groove on the first active material stack up to at least the level of the top of the side walls;
F. defining two different zones along the longitudinal axis XX of the integrated optoelectronic device, comprising a first zone and a second zone;
G. within the second zone, selectively etching the different stacks and layers filling the first groove down to the bottom of the first groove, to form a second groove with a U-shaped cross section of width W;
H. within said second zone, performing an epitaxial growth of a second active material stack to fill said second groove on the layer of n-doped III-V semi-conductor, said second active material stack being in line with the first active material stack;
I. within said second zone, performing an epitaxial growth of p-doped III-V semi-conductor material to fill said second groove on the second active material stack up to at least the level of the top of the side walls;
J. within the first zone, etching along the longitudinal axis (XX) at least below the level of the first active material stack a first pair of longitudinal channels, each located along each side wall so as to define a first central stripe portion of width w_{S1} comprising the etched first active material stack constituting the optical waveguide SOA and the etched layer of p-doped III-V semi-conductor, said first zone constituting the SOA zone;
K. within the second zone, etching along the longitudinal axis XX at least below the level of the second active material stack, a network of grooves having an H-shaped top cut and comprising:
   ▪ a second pair of longitudinal channels, each located along each side wall, to define a second central stripe portion of width w_{S2} comprising the etched second active material stack constituting the optical waveguide PIN and the etched layer of p-doped III-V semi-conductor, all together forming the PIN zone,
   ▪ an intersectional groove with a U-shaped cross section of width W and being located between the SOA zone and the PIN zone, thus forming an intersectional zone, said intersectional groove communicating with the first and second pairs of longitudinal channels;
   ▪ an end groove with a U-shaped cross section of width W and being located at the end of the PIN zone that is opposite to the SOA zone, thus forming an end zone, said end groove communicating with the second pair of longitudinal channels;
L. inside the first pair of longitudinal channels and the network of grooves, performing regrowth of a semi-insulating stack up to at least the level of the top of the layer of p-doped III-V semi-conductor,
M. depositing, along said longitudinal axis XX, metal stripes on the top of the side walls and on the top of the first and second central stripe portions, the metal stripe located on the second stripe portion extending on the semi-insulating stack of the end zone;
N. forming an electrical separation between the PIN zone and the SOA zone in the intersectional zone by implanting H+ ions within a thin ribbon of implanted H+ located between the side walls and perpendicular to longitudinal axis XX.

Advantageously, the method of fabrication according to the invention may further comprise, between steps B and C, a step B' of depositing a first dielectric mask on said layer of n-doped III-V semi-conductor to form a first masked stack, so that the selective etching of step C) consists in etching the first masked stack.

Advantageously, steps E and I may comprise the epitaxial growth at least a p-InP layer and a p-doped III-V semi-conductor contact layer for constituting the layer of p-doped III-V semi-conductor.

Advantageously, the method of fabrication according to the invention may further comprise, between steps F and G, a step F' of depositing, within the first zone, a second dielectric mask (62) for covering at least the layer of p-doped III-V semi-conductor to form a second masked stack.

Advantageously, the method of fabrication according to the invention may further comprise, between steps I and J, a step I' of removing the remaining portions of the first and second dielectric masks and depositing a third dielectric mask covering the top surface of the first and second zones.

Advantageously, the method of fabrication according to the invention may further comprise, between steps L and M, a step L' of removing the remaining portions of the third dielectric mask.

Advantageously, the method of fabrication according to the invention, may further comprise, between steps L and M, a step L'' of chemical and/or mechanical surface stripping of the regrown semi-insulating stack, to flatten it to the level of the top of the side walls.

Advantageously, step N of forming an electrical separation between the PIN zone and the SOA zone in the intersectional zone may be realized by implanting H+ ions within a thin ribbon of implanted H+ located between the side walls (21, 22) and perpendicular to longitudinal axis XX.

### BRIEF DESCRIPTION OF THE DRAWINGS

Some example embodiments are now described, by way of example only, and with reference to the accompanying drawings in which:
- FIG. 1 schematically represents two sectional views of Semi-Insulating Buried Heterostructures (SIBH) realized by a state-of-the-art one-step process of manufacture;
- FIG. 2 schematically represents these two sectional views of Semi-Insulating Buried Heterostructures (SIBH) realized by a state of the art one-step process of manufacture in which pillars are generated for obtaining structures with metal contacts at the same level;
- FIGs. 3a to 3c schematically represent two embodiments of an integrated optoelectronic device D according to the present invention;
- FIG. 4 schematically represents the electrical scheme of the device;
- FIGs. 5 to 13 together with FIG.3 schematically represent the different steps of the process flow for fabricating the integrated optoelectronic device D according to the embodiments represented in figures 3a-c:
   ∘ FIG. 5 schematically represents steps A, B, B' and C;
   ∘ FIG. 6 schematically represents steps D and E;
   ∘ FIG. 7 schematically represents steps F, F' and G;
   ∘ FIG. 8 schematically represents steps H and I;
   ∘ FIG. 9 schematically represents step I';
   ∘ FIG. 10 schematically represents steps J and K;
   ∘ FIG. 11 schematically represents step L;
   ∘ FIG. 12 schematically represents step L';
   ∘ FIG. 13 schematically represents step L'';
   ∘ FIG. 3 schematically represents steps M and N.

The same reference number represents the same element or the same type of element on all drawings, unless stated otherwise.

### DETAILLED DESCRIPTION

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention and are to be construed as being without limitation to such specifically recited examples and conditions. As a result, the invention is not limited to the specific embodiments or examples described below, but by the claims and their equivalents.

In the following description, well-known functions or constructions by the man skilled in the art are not described in detail since they might obscure the invention in unnecessary detail.

In the following description of the figures, schematic representations are non-limiting and serve only for the understanding of the invention.

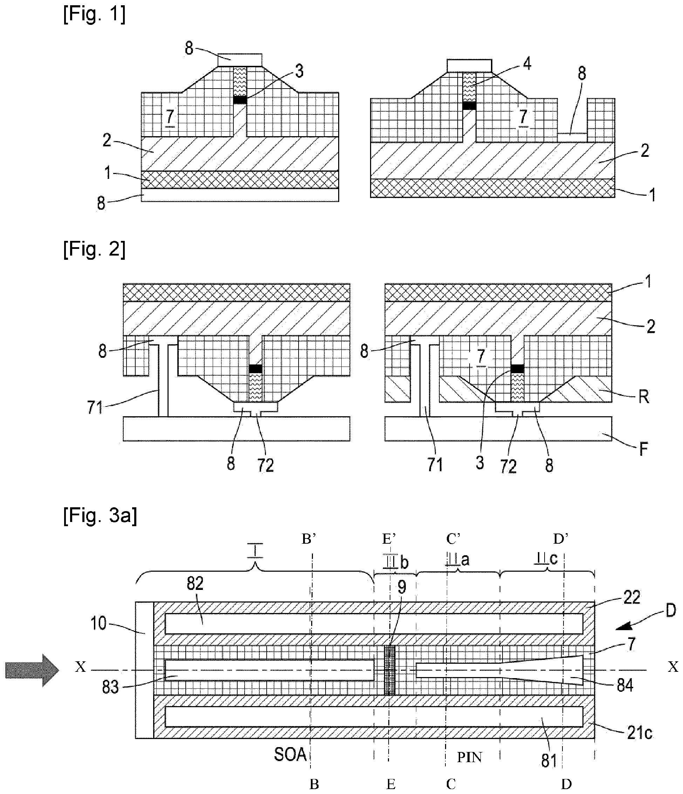

FIG. 1 schematically represents two sectional views of Semi-Insulating Buried Heterostructures (SIBH) realized by a state-of-the-art one-step process of manufacture. In particular, FIG. 1 shows that a metal contact 8 is deposited on a p-doped III-V semiconductor 4 and/or on the front side of the n doped III-V semi-conductor 2 (see FIG. 1, right scheme). The last solution implies the etching of a via 70 in the SIBH layer 7 until reaching a doped III-V layer 2 connected to the III-V substrate 1. The optoelectronic device obtained by this SiBH technology is not flat, especially around the waveguide 3, because of the different growths of the [100] [110] or [111] crystallographic lattices. Moreover, the metal contacts 8 are not at the same level. It imposes to generate pillars 71, 72 for the via contact on the device or on the flip chip package F as shown by FIG. 2. FIG. 2 schematically represents two sectional views of the Semi-Insulating Buried Heterostructures (SIBH) of FIG. 1 in which pillars 71, 72 are generated for obtaining structures with metal contacts 8 at the same level, one of the structures being encapsulated in a resin R for overcoming mechanical weakness issues (see FIG. 2, right scheme 2). However, it generates a thermal resistivity. A bad heat evacuation strongly penalizes the performances of the chip.

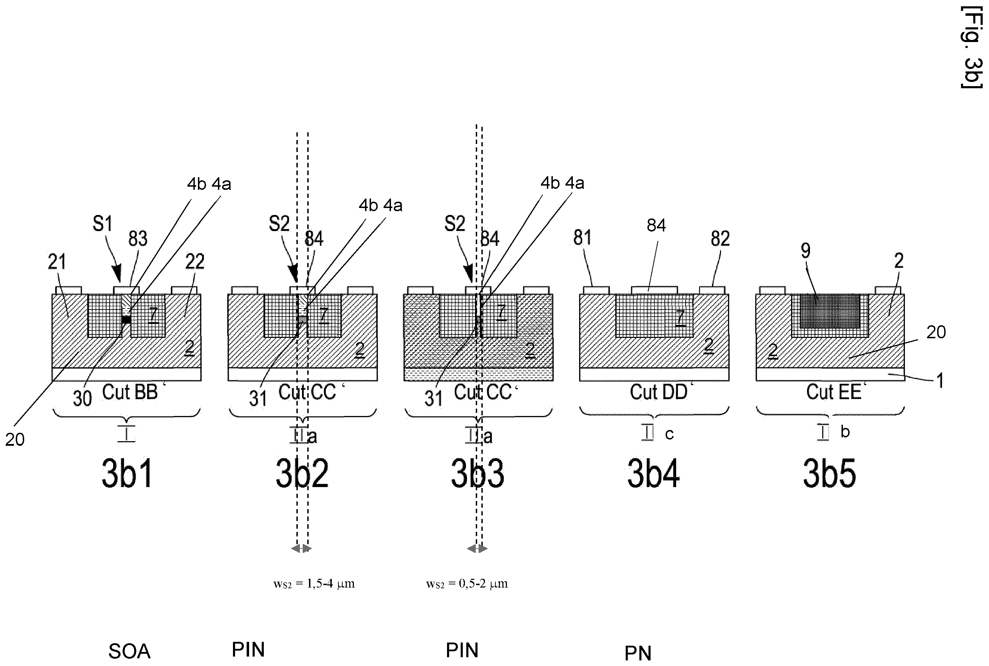

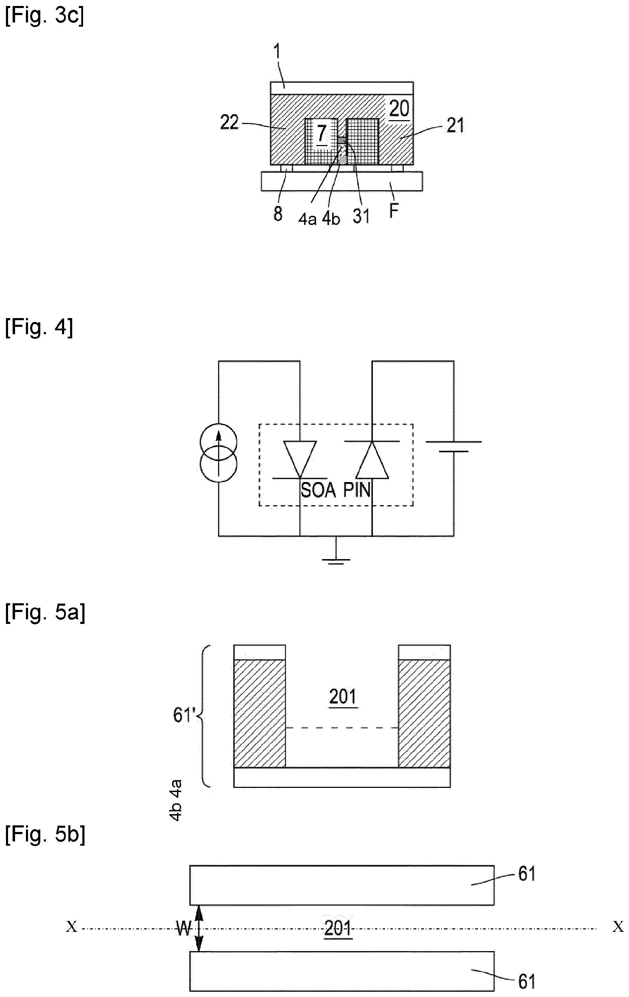

FIGs. 3a to 3c schematically represent two specific embodiments (respectively corresponding to an embodiment with a narrow waveguide PIN and to an embodiment with a large PIN waveguide) of an integrated optoelectronic device D according to the present invention that overcomes the above-mentioned drawbacks. The figures show:
- a top view applying to both embodiments,
- five sectional views of the SiBH heterostructures of these embodiments according to the B-B', C-C', D-D' and E-E' planes, FIGs. 3b1, 3b4 and 3b5 applying to both examples, and FIGs. 3b2 and 3b3 (cross-sectional views according the C-C' planes) applying respectively to the first and second embodiments;
- an additional sectional view (Fig. 3c) of the SOA-PIN device D according to the C-C' plane (and corresponding to the cross-sectional view of FIG. 3b3), the SOA-PIN device D device being flip-chipped on an electronic package.

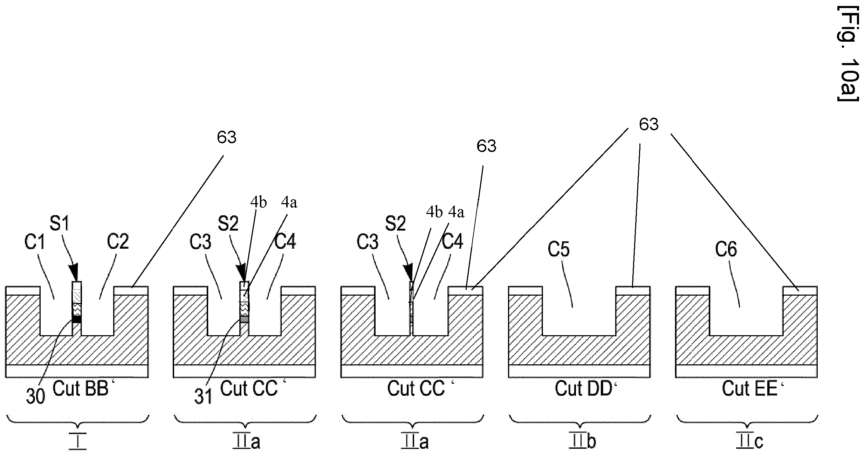

With respect to both examples of the SOA-PIN device D, FIGs. 3a and 3b show that it comprises:
- a substrate 1 made of III-V semiconductor material, the device D being positioned alongside a longitudinal axis XX of said substrate layer,
- a layer of n-doped III-V semi-conductor 2 deposited on said substrate 1, said layer of n-doped III-V semi-conductor 2 being etched to present a base 20 surrounded by two side walls 21, 22 (see FIG. 3b,3c), within a first zone I of the integrated optoelectronic device D alongside the longitudinal axis XX, this first zone further comprising:
   ▪ a first central stripe portion S1 comprising a buried optical waveguide SOA 30 on which is grown a layer of p-doped III-V semi-conductor material 4 comprising at least a p-InP layer 4a and a p-doped III-V semi-conductor contact layer 4b at least up to the level of the top of the side walls 21, 22 (see FIGs 3a and 3b1),
   ▪ a first pair of longitudinal channels C1, C2 (see FIG. 10a clearly showing the non-filled channels) each located along each side wall 21, 22 on both sides of the first central stripe portion S1, the longitudinal channels C1, C2 being each filled by a regrown semi-insulating stack 7 from the base 20 up to the level of the top of the layer of p-doped III-V semi-conductor material 4 (see FIGs 3a and 3b1),
   ▪ the first zone I constituting the SOA zone, and the remaining zone of device D constituting the second zone II,
- within said second zone II (see FIGs 3a, 3b2 to 3b4) one can identify:
   ▪ a PIN zone (IIa) comprising :
      - a second central stripe portion S2 of width w_{S2} comprising a buried optical waveguide PIN 31 (see Fig. 3c) on which is grown a layer of p-doped III-V semi-conductor material 4 comprising at least a p-InP layer 4a and a p-doped III-V semi-conductor contact layer 4b at least up to the top of the side walls 21, 22, the optical waveguide PIN 31 being in line with optical waveguide SOA 30 along the longitudinal axis XX and at the same level from the base 20 (see FIGs. 3a, 3b2 and 3b3),
      - a second pair of longitudinal channels C3, C4 (clearly shown in FIG. 10a) each located along each side wall 21, 22 on both sides of the second central stripe portion S2, the longitudinal channels C3, C4 being each filled by a regrown semi-insulating stack 7 up to the top of the layer of p-doped III-V semi-conductor material 4 (see FIGs. 3a, 3b2 and 3b3),
   ▪ an intersectional zone IIb located between the SOA zone I and the PIN zone IIa and being filled by the regrown semi-insulating stack 7 from the base (20) up to the top of the layer of p-doped III-V semi-conductor material 4 (see FIGs. 3a and 3b5), and
   ▪ an end zone IIc located at the end of the PIN zone IIa that is opposite to the SOA zone I, said end zone IIc being filled by the regrown semi-insulating stack 7 from the base 20 up to the level of the top of the layer of p-doped III-V semi-conductor material 4 (see FIGs. 3a and 3b4);
   ▪ metal stripes 81, 82 covering the top of the side walls 21, 22 and metal stripes 83, 84 covering respectively the top of the first and second central stripe portions S1, S2, the metal stripe 84 covering the second stripe portion S2 also extending over the semi-insulating stack 7 of the end zone IIc (see FIG. 3a and 3b), and
   ▪ an electrical separation 9 between the PIN zone IIa and the SOA zone I consisting of a ribbon of implanted H+ located in the intersectional zone IIb between the side walls 21, 22 perpendicular to longitudinal axis XX see FIG. 3a and 3b5.

FIG. 3a shows that an anti-reflective coating 10 (Rmin) is deposited on the front face of the device D to obtain a good coupling between the incident optical signal (represented by a left thick arrow) and the device D. It is realized with dielectric layers like Al₂O₃, TiO₂ and SiO₂, whose thickness are adjusted to permit this low optical reflectivity.

FIG. 3b shows that the p and n contact are on the upper side of the wafer at the same level.

FIGs. 3b2 and 3b3 correspond respectively to the vertical cut of the PIN section (IIa) with a large optical wave guide (cut CC on figure 3a) and the vertical cut of the PIN section with a narrow optical wave guide (cut CC on figure 3a).

FIG. 3c shows an embodiment with metal contacts 81, 82, 83, 84 soldered on the flip-chip package F. The mechanical weakness is thus suppressed. Minimizing the wire bonding permits to limit the Joule effect due to the current intensity and to limit parasitic electric impedance. The heat produced by the photon generation in the SOA (zone I) and the photon detection in the PIN (zone IIb) can be easily evacuated because there is no resin generating a thermal resistivity.

The opto-electronic device D thus comprises a semiconductor optical amplifier (SOA - zone I) working in a continuous wave condition and a PIN photodiode (zone IIb), able to detect high frequencies amplified incident optical signals. The SOA amplification pushes the PIN performances to its limits with yet small optical power. The integration of the optical functions is based on a butt-joint technology. By this way, Multiple Quantum Wells can be optimized in every optical function. An H+ implantation 9 is localized to separate electrically the direct-biased SOA I from the reverse-biased PIN IIb.

FIG. 4 schematically represents the electrical scheme or equivalent circuit of the SOA-PIN device D: the SOA function (in zone I) is powered by a current generator and the PIN function (in zone IIb) is polarized by a voltage generator. Both current generator and voltage generator are external to the device D and can be connected to the devices using the contact layers.

FIGs. 5 to 13 together with the above-described FIG. 3 schematically represent the different steps of the process flow for fabricating an opto-electronic device D according to the embodiments represented in figure 3.

In particular, FIG. 5 schematically represents step A to C; being composed in detail of:
A. providing a substrate 1 made of III-V semiconductor material with a longitudinal axis XX;
B. performing an epitaxial growth of a layer of n-doped III-V semi-conductor 2 on the substrate 1;
B' depositing a first dielectric mask 61 on the layer of n-doped III-V semi-conductor 2 to form a first masked stack 61';
C. etching the first stack masked 61' down to the level of the substrate 1 to form a first groove 201 with a U-shaped cross section of width W and thus to define a base 20 and side walls 21, 22.

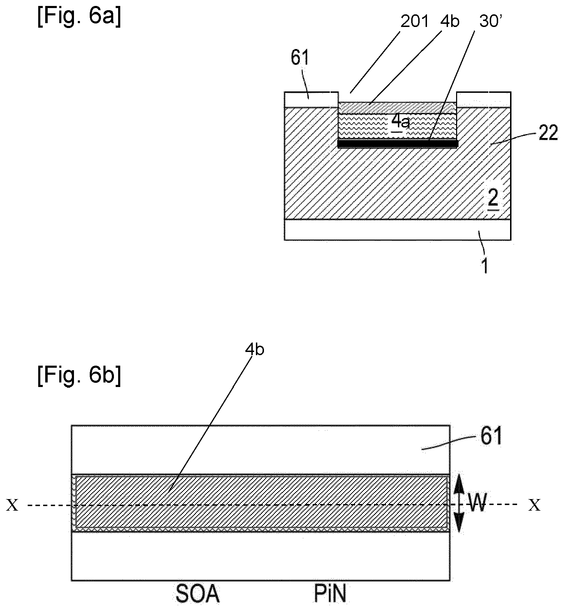

Then, FIG. 6 represents step D to E being composed in detail of:
D. performing an epitaxial growth of a layer of n-doped III-V semi-conductor 2 and a first active material stack 30' to fill the first groove 201 on the layer of the regrown n-doped III-V semi-conductor 2; and
E. performing an epitaxial growth of a layer of p-doped III-V semi-conductor material 4 comprising at least a p-InP layer 4a and a p-doped III-V semi-conductor contact layer 4b to fill said first groove 201 on the first active material stack 30' up to at least the level of the top of the side walls 21, 22.

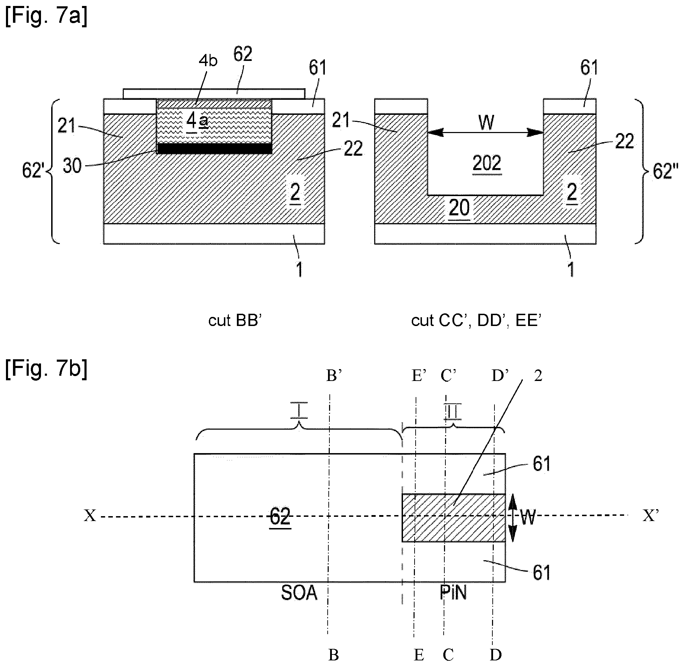

Then, within a zone of the SOA-PIN integrated optoelectronic device D along the longitudinal axis XX constituting the first zone I (this zone being defined during a step F of defining two different zones along the longitudinal axis XX of the integrated optoelectronic device D), a second dielectric mask 62 is formed (step F') for covering at least the layer of p-doped III-V semi-conductor material 4 to form a second masked stack 62', the remaining zone constituting the second zone II (FIG. 7a, left part). Within said second zone II, the second stack covered with a mask 62' is etched down to the level of the first groove 201 to form a second groove 202 (step G) with a U-shaped cross section of width W (FIG. 7a, left part).

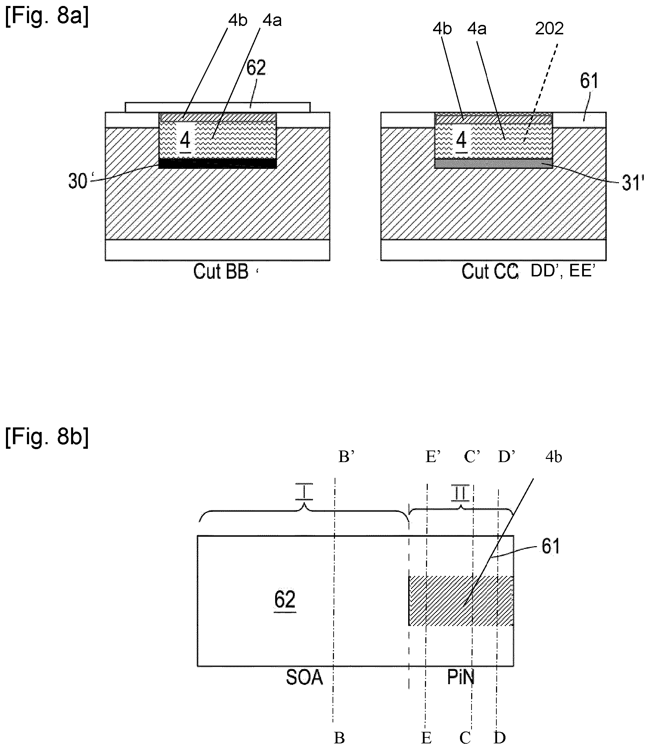

FIG. 8 shows that step G is followed by the epitaxial growing of a second active material stack 31' within the second zone II, to fill said second groove 202 on the layer of the n-doped III-V semi-conductor 2 (step H), this second active material stack 31' being in line with the first active material stack 30' (FIG. 7a, right part).

Then, within said second zone II, step H is followed by the performing an epitaxial growth of p-doped III-V semi-conductor material 4 comprising at least a p-InP layer 4a and a p-doped III-V semi-conductor contact layer 4b (step I) to fill the second groove 202 on the second active material stack 31' up to at least the level of the top of the side walls 21, 22.

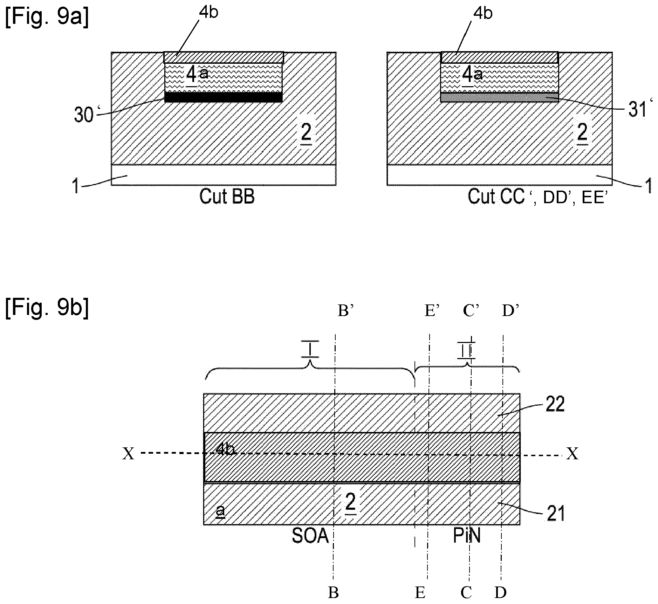

FIG. 9 schematically represents step I', wherein the remaining portions of the first and second dielectric masks 61, 62 are removed (step K). Then a third dielectric mask 63 is formed so as to cover at least the top surface of the first and second zones I and II (this step is not illustrated in figure 9).

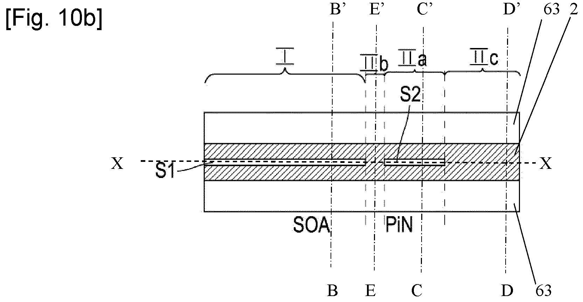

FIG. 10 shows that, within said second zone II, a first pair of longitudinal channels C1, C2 is etched at least below the level of the first active material stack 30' (step J), each channel being located along each side wall 21, 22 so as to define a first central stripe portion S1 of width w_{S1} comprising the etched first active material stack 30 constituting the optical waveguide SOA 3) and the etched layer of p-doped III-V semi-conductor material 4, the first zone (I) constituting the SOA zone.

FIG. 10 also shows that, within the second zone II, a network of grooves C3, C4, C5, C6 having an H-shaped top cut is etched along the longitudinal axis XX at least below the level of the second active material stack 31', said network of grooves C3, C4, C5, C6 , said network of grooves C3, C4, C5, C6 comprising (step K): a second pair of longitudinal channels C3, C4, each located along each side wall 21, 22 so as to define a second central stripe portion S2 of width w_{S2} comprising the etched second active material stack 31' constituting the optical waveguide PIN 31 and the etched layer of p-doped III-V semi-conductor material 4, all together forming the PIN zone IIa,
▪ an intersectional groove C5 with a U-shaped cross section of width W and being located between the SOA zone I and the PIN zone IIa, thus forming an intersectional zone (IIb), the intersectional groove C5 communicating with the first C1, C2 and second C3, C4 pairs of longitudinal channels;
▪ an end groove C6 with a U-shaped cross section of width W and being located at the end of the PIN zone (II) that is opposite to the SOA zone I, thus forming an end zone (IIc), said end groove C6 communicating with the second pair of longitudinal channels C, C4.

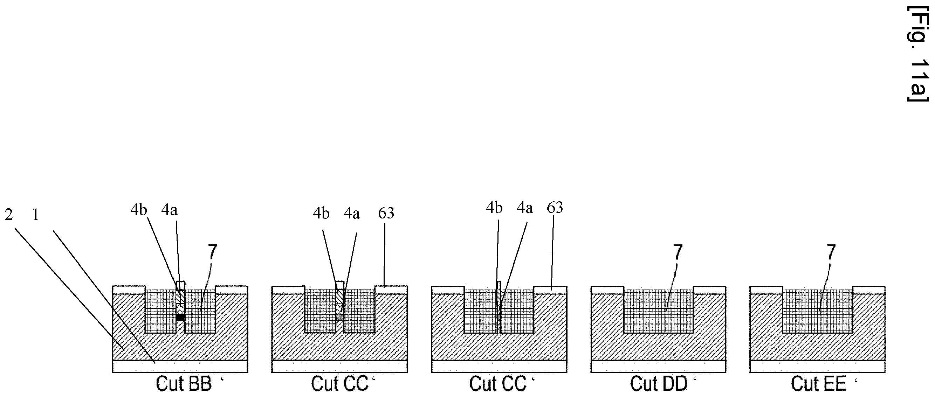

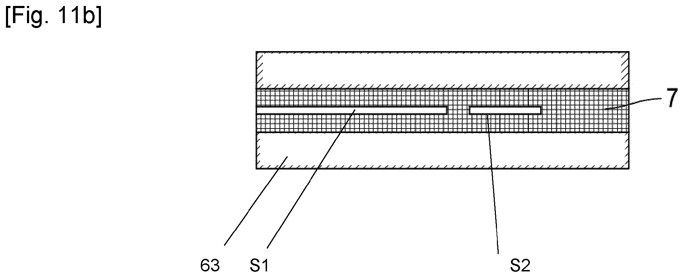

The stripes can have different widths in function of the optical functions (see FIG. 10, and also below FIG. 11). It is particularly interesting to define a narrow optical guide (having a width W_{S2} comprised between 0,5 µm and 2 µmm) in the PIN section (IIa) in order to limit the capacitance of the PIN. This case is illustrated in the third vertical cut according the CC plan and second overview sketch of FIG. 10a. The SOA and the PIN can be connected by n and p InP (n-doped III-V semiconductor and p-doped III-V semiconductor in figure 4f), but it is more advantageous to etch the interconnection (IIb) and to fill the cavity C5 with semi insulating InP, in order to improve the PIN capacitance. The insulated section is processed for the future modulation electrical contact of the PIN.

There is an interface between the SOA zone I and the intersectional zone IIb, usually called butt-joint.

Besides a taper pattern during the mask patterning in the SOA zone I in front of the PIN section can be advantageous for a better optical coupling.

FIG.11 shows the next step L, in which, inside the first pair of longitudinal channels C1, C2 and the network of grooves C3, C4, C5, C6, a semi-insulating stack 7 (such as InP) is regrown up to at least the level of the top of the layer of p-doped III-V semi-conductor 4.

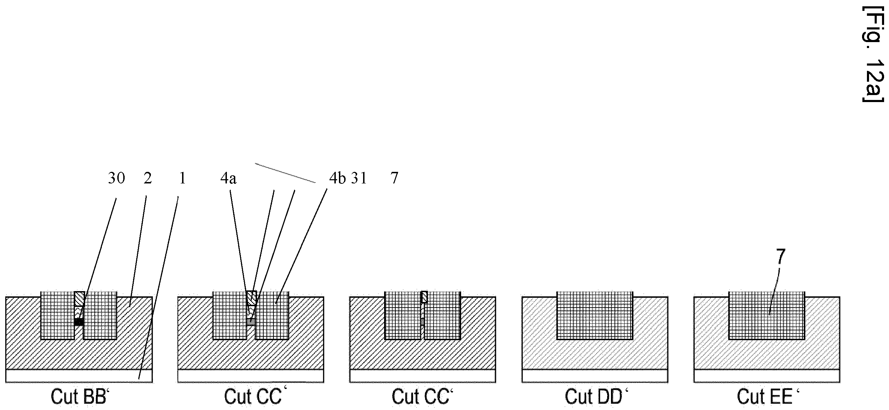

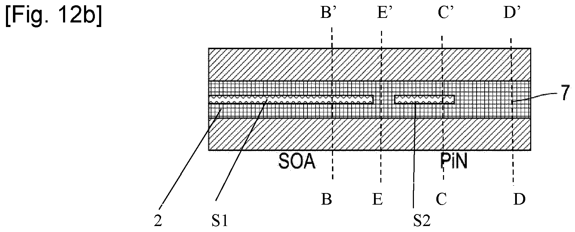

Then the remaining portions of the third dielectric mask 63 are removed (step L', see FIG. 12).

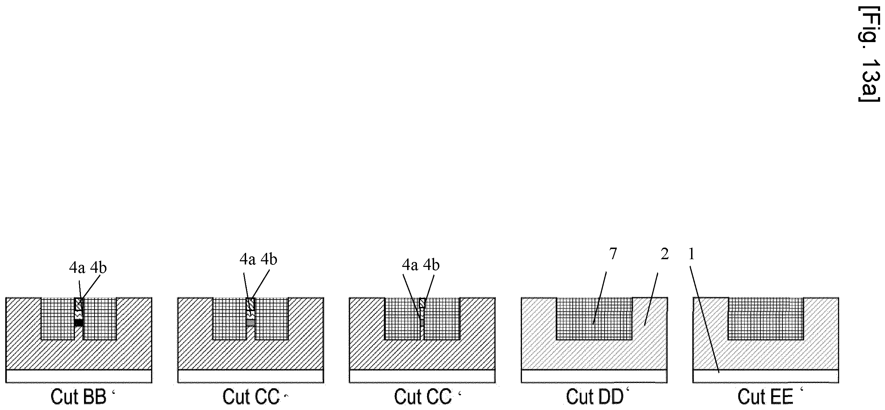

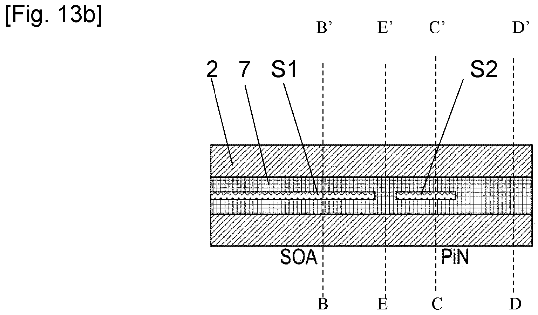

Then, a step L'' of chemical and/or mechanical surface stripping of the regrown semi-insulating stack 7 may be performed, to flatten it to the level of the top of the side walls 21, 22, inside the first pair of longitudinal channels C1, C2 and the network of grooves C3, C4, C5, C6, a semi-insulating stack 7 up is regrown to at least the level of the top of the layer of p-doped III-V semi-conductor 4 (see FIG. 13).

FIG. 3 shows the two last steps of the process of fabrication which comprises:
M. depositing, along said longitudinal axis XX, metal stripes 8, 82, 83 on the top of the side walls 21, 22 and on the top of the first and second central stripe portions S1, S2, the metal stripe 84 located on the second stripe portion S2 extending on the semi-insulating stack 7 of the end zone IIc; and
N. forming an electrical separation 9 between the PIN zone IIa and the SOA zone I in the intersectional zone IIb by implanting H+ ions within a thin ribbon of implanted H+ located between the side walls 21, 22 and perpendicular to longitudinal axis XX.

It is interesting to deposit a large contact for the PIN IIa on the semi-insulating section 7 in order to make easier the soldering of the contact on the flip-chip package F. However, the metal contacts 81, 82, 83, 84 must stays on the p-semiconductor 2and the semi insulating InP 7 to avoid an electric short cut between the p and n semiconductors. The high frequency capacitance is only limited by the width of the p-semiconductor 2.

## Claims

1. Integrated optoelectronic device (D) comprising:
- a substrate (1) comprising at least a III-V semiconductor material,
▪ a layer of n-doped III-V semi-conductor (2) disposed on said substrate (1), said layer of n-doped III-V semi-conductor (2) presenting a base (20) and two side walls (21, 22), so that said layer of n-doped III-V semi-conductor (2) has a U-Shaped cross section;
▪ within a first zone (I) along a longitudinal axis (XX) of the integrated optoelectronic device (D):
∘ a first central stripe portion (S1) comprising a buried optical waveguide Semiconductor Optical Amplifier (30), SOA,
∘ a first pair of longitudinal channels (C1, C2) each located along each side wall (21, 22) on both sides of the first central stripe portion (S1),
∘ said first zone (I) constituting the SOA zone, and the remaining zone constituting the second zone (II);
▪ within said second zone (II) along said longitudinal axis (XX) :
∘ a PIN photodiode zone (IIa) comprising:
▪ a second central stripe portion (S2) comprising a buried optical waveguide PIN photodiode (31), said optical waveguide PIN photodiode (31) being in line with the optical waveguide Semiconductor Optical Amplifier (30) along the longitudinal axis (XX) and at the same level from the base (20),
▪ a second pair of longitudinal channels (C3, C4) each located along each side wall (21, 22) on both sides of the second central stripe portion (S2),
∘ an intersectional zone (IIb) located between the SOA zone (I) and the PIN photodiode zone (IIa),
∘ an end zone (IIc) located at the end of the PIN photodiode zone (IIa) that is opposite to the SOA zone (I),
▪ metal stripes (81, 82) covering the top of the side walls (21, 22) and metal stripes (83, 84) covering respectively the top of the first and second central stripe portions (S1, S2),
▪ an electrical separation (9) between the PIN photodiode zone (IIa) and the SOA zone (I) between the side walls (21, 22) perpendicular to longitudinal axis (XX);
wherein said buried optical waveguide Semiconductor Optical Amplifier (30) of the first central stripe portion (S1) comprises at least Multi Quantum Wells or Quantum dots, that are coated by a layer of p-doped III-V semi-conductor material (4) comprising at least a p-InP layer (4a) and a p-doped III-V semi-conductor contact layer (4b) at least up to the level of the top of the side walls (21, 22);
wherein said longitudinal channels (C1, C2) are each filled by a regrown semi-insulating stack (7) from the base (20) up to the level of the top of the layer of p-doped III-V semi-conductor material (4) .

2. Integrated optoelectronic device (D) according to claim 1, wherein said buried optical waveguide PIN (31) of the second central stripe portion (S2) comprises at least Multi Quantum Wells or Quantum dots, that are by coated by a layer of p-doped III-V semi-conductor (4) comprising at least a p-InP layer (4a) and a p-doped III-V semi-conductor contact layer (4b) at least up to the top of the side walls (21, 22).

3. Integrated optoelectronic device (D) according to anyone of claims 1 to 2, wherein said longitudinal channels (C3, C4) are each filled by a regrown semi-insulating stack (7) up to the top of the layer of p-doped III-V semi-conductor (4).

4. Integrated optoelectronic device (D) according to anyone of claims 1 to 3, wherein said intersectional zone (IIb) is filled by the regrown semi-insulating stack (7) from the base (20) up to the top of the layer of p-doped III-V semi-conductor (4).

5. Integrated optoelectronic device (D) according to anyone of claims 1 to 4, wherein said end zone (IIc) is filled by the regrown semi-insulating stack (7) from the base (20) up to the level of the top of the layer of p-doped III-V semi-conductor (4).

6. Integrated optoelectronic device (D) according to anyone of claims 1 to 5, wherein the metal stripe (84) covering the second stripe portion (S2) also extends over the semi-insulating stack (7) of the end zone (IIc).

7. Integrated optoelectronic device (D) according to anyone of claims 1 to 5, wherein said electrical separation (9) comprises a ribbon of implanted H+ located in the intersectional zone (IIb) between the side walls (21, 22) perpendicular to the longitudinal axis (XX).

8. Method of fabricating an integrated optoelectronic device (D), said method comprising:
A. providing a substrate (1) made of III-V semiconductor material with a longitudinal axis (XX);
B. performing an epitaxial growth of a layer of n-doped III-V semi-conductor (2) on the substrate (1);
C. selectively etching said layer of n-doped III-V semi-conductor (2) down to the level of said substrate (1) to form a first groove (201) with a U-shaped cross section of width W to define a base (20) and side walls (21, 22);
D. performing an epitaxial growth of a layer of n-doped III-V semi-conductor (2) and a first active material stack (30') to fill the first groove (201) on the layer of the regrown n-doped III-V semi-conductor (2);
E. performing an epitaxial growth of a layer of p-doped III-V semi-conductor (4) to fill said first groove (201) on the first active material stack (30') up to at least the level of the top of the side walls (21, 22);
F. defining two different zones along the longitudinal axis (XX) of the integrated optoelectronic device (D), comprising a first zone (I) and a second zone (II);
G. within the second zone (II), selectively etching the different stacks and layers filling the first groove (201) down to the bottom of the first groove (201), to form a second groove (202) with a U-shaped cross section of width W;
H. within said second zone (II), performing an epitaxial growth of a second active material stack (31') to fill said second groove (202) on the layer of n-doped III-V semi-conductor (2), said second active material stack (31') being in line with the first active material stack (30');
I. within said second zone (II), performing an epitaxial growth of p-doped III-V semi-conductor material (4) to fill said second groove (202) on the second active material stack (31') up to at least the level of the top of the side walls (21, 22);
J. within the first zone (I), etching along the longitudinal axis (XX) at least below the level of the first active material stack (30') a first pair of longitudinal channels (C1, C2), each located along each side wall (21, 22) so as to define a first central stripe portion (S1) comprising the etched first active material stack (30') constituting the optical waveguide Semiconductor Optical Amplifier (30) and the etched layer of p-doped III-V semi-conductor material (4), said first zone (I) constituting the Semiconductor Optical Amplifier zone;
K. within the second zone (II), etching along the longitudinal axis (XX) at least below the level of the second active material stack (31'), a network of grooves (C3, C4, C5, C6) having an H-shaped top cut and comprising:
▪ a second pair of longitudinal channels (C3, C4), each located along each side wall (21, 22), to define a second central stripe portion (S2) comprising the etched second active material stack (31') constituting the optical waveguide PIN (31) and the etched layer of p-doped III-V semi-conductor material (4), all together forming the PIN zone (IIa),
▪ an intersectional groove (C5) with a U-shaped cross section of width W and being located between the SOA zone (I) and the PIN zone (IIa), thus forming an intersectional zone (IIb), said intersectional groove (C5) communicating with the first (C1, C2) and second (C3, C4) pairs of longitudinal channels;
▪ an end groove (C6) with a U-shaped cross section of width W and being located at the end of the PIN zone (IIb) that is opposite to the SOA zone (I), thus forming an end zone (IIc), said end groove (C6) communicating with the second pair of longitudinal channels (C3, C4);
L. inside the first pair of longitudinal channels (C1, C2) and the network of grooves (C3, C4, C5, C6), performing regrowth of a semi-insulating stack (7) up to at least the level of the top of the layer of p-doped III-V semi-conductor material (4);
M. depositing, along said longitudinal axis (XX), metal stripes (81, 82, 83) on the top of the side walls (21, 22) and on the top of the first and second central stripe portions (S1, S2), the metal stripe (84) located on the second stripe portion (S2) extending on the semi-insulating stack (7) of the end zone (IIc);
N. forming an electrical separation (9) between the PIN zone (IIa) and the SOA zone (I) in the intersectional zone (IIb).

9. Method of fabrication according to claim 8, further comprising, between steps B and C, a step B' of depositing a first dielectric mask (61) on said layer of n-doped III-V semi-conductor (2) to form a first masked stack (61'), so that the selective etching of step C) consists in etching the first masked stack (61').

10. Method of fabrication according to anyone of claims 8 or 9, wherein steps E and I comprises the epitaxial growth at least a p-InP layer (4a) and a p-doped III-V semi-conductor contact layer (4b) for constituting the layer of p-doped III-V semi-conductor (4).

11. Method of fabrication according to claim 9, further comprising, between steps F and G, a step F' of depositing, within the first zone (I), a second dielectric mask (62) for covering at least the layer of p-doped III-V semi-conductor (4) to form a second masked stack (62').

12. Method of fabrication according to claim 11, further comprising, between steps I and J, a step I' of removing the remaining portions of the first and second dielectric masks (61, 62) and depositing a third dielectric mask (63) covering the top surface of the first and second zones (I, II).

13. Method of fabrication according to claim 12, further comprising, between steps L and M, a step L' of removing the remaining portions of the third dielectric mask (63).

14. Method of fabrication according to anyone of claims 8 to 13, further comprising, between steps L and M, a step L'' of chemical and/or mechanical surface stripping of the regrown semi-insulating stack (7), to flatten it to the level of the top of the side walls (21, 22).

15. Method of fabrication according to anyone of claims 8 to 14, wherein step N of forming an electrical separation (9) between the PIN zone (IIa) and the SOA zone (I) in the intersectional zone (Iib) is realized by implanting H+ ions within a thin ribbon of implanted H+ located between the side walls (21, 22) and perpendicular to longitudinal axis (XX).

## Patentansprüche

1. Integrierte optoelektronische Vorrichtung (D), die Folgendes umfasst:
- ein Substrat (1), das mindestens ein III-V-Halbleitermaterial umfasst,
**■** eine Schicht eines n-dotierten III-V-Halbleiters (2), die auf dem Substrat (1) angeordnet ist, wobei die Schicht eines n-dotierten III-V-Halbleiters (2) eine Basis (20) und zwei Seitenwände (21, 22) präsentiert, derart, dass die Schicht eines n-dotierten III-V-Halbleiters (2) einen U-förmigen Querschnitt aufweist;
**■** in einer ersten Zone (I) entlang einer Längsachse (XX) der integrierten optoelektronischen Vorrichtung (D):
∘ einen ersten Streifenabschnitt (S1), der einen versenkten optischen Lichtwellenleiter-Halbleiterverstärker (30), SOA, umfasst,
∘ ein erstes Paar von Längskanälen (C1, C2), von denen sich jeder entlang jeder Seitenwand (21, 22) auf beiden Seiten des ersten zentralen Streifenabschnitts (S1) befindet,
∘ wobei die erste Zone (I) die SOA-Zone konstituiert und die verbleibende Zone die zweite Zone (II) konstituiert;
**■** in der zweiten Zone (II) entlang der Längsachse (XX):
∘ eine PIN-Fotodiodenzone (IIa), die Folgendes umfasst:
**■** einen zweiten zentralen Streifenabschnitt (S2), der eine versenkte optische Lichtwellenleiter-PIN-Fotodiode (31) umfasst, wobei die optische Lichtwellenleiter-PIN-Fotodiode (31) mit dem optischen Lichtwellenleiter-Halbleiterverstärker (30) entlang der Längsachse (XX) und auf derselben Ebene von der Basis (20) in Linie ist,
**■** ein zweites Paar von Längskanälen (C3, C4), von denen sich jeder entlang jeder Seitenwand (21, 22) auf beiden Seiten des zweiten zentralen Streifenabschnitts (S2) befindet,
∘ eine Überschneidungszone (IIb), die sich zwischen der SOA-Zone (I) und der PIN-Fotodiodenzone (IIa) befindet,
∘ eine Endzone (IIc), die sich am Ende der PIN-Fotodiodenzone (IIa) befindet, die der SOA-Zone (I) gegenüberliegt,
**■** Metallstreifen (81, 82), die die Oberseite der Seitenwände (21, 22) abdecken, und Metallstreifen (83, 84), die jeweils die Oberseite des ersten und des zweiten zentralen Streifenabschnitts (S1, S2) abdecken,
**■** eine elektrische Trennung (9) zwischen der PIN-Fotodiodenzone (IIa) und der SOA-Zone (I) zwischen den Seitenwänden (21, 22) senkrecht zur Längsachse (XX);
wobei der versenkte optische Lichtwellenleiter-Halbleiterverstärker (30) des ersten zentralen Streifenabschnitts (S1) mindestens Multiquantentöpfe oder Quantenpunkte umfasst, die mit einer Schicht von p-dotiertem III-V-Halbleitermaterial (4) beschichtet sind, das mindestens eine p-InP-Schicht (4a) und eine p-dotierte III-V-Halbleiterkontaktschicht (4b) mindestens bis zur Ebene der Oberseite der Seitenwände (21, 22) umfasst;
wobei die Längskanäle (C1, C2) jeweils mit einem neu aufgebauten halbisolierenden Stapel (7) von der Basis (20) bis zur Ebene der Oberseite der Schicht eines p-dotierten III-V-Halbleitermaterials (4) gefüllt sind.

2. Integrierte optoelektronische Vorrichtung (D) nach Anspruch 1, wobei die versenkte optische Lichtwellenleiter-PIN (31) des zweiten zentralen Streifenabschnitts (S2) mindestens Multiquantentöpfe oder Quantenpunkte umfasst, die mit einer Schicht eines p-dotierten III-V-Halbleiters (4) beschichtet sind, die mindestens eine p-InP-Schicht (4a) und eine p-dotierte III-V-Halbleiterkontaktschicht (4b) mindestens bis zur Oberseite der Seitenwände (21, 22) umfasst.

3. Integrierte optoelektronische Vorrichtung (D) nach einem der Ansprüche 1 bis 2, wobei die Längskanäle (C3, C4) jeweils mit einem neu aufgebauten halbisolierenden Stapel (7) bis zur Oberseite der Schicht eines p-dotierten III-V-Halbleitermaterials (4) gefüllt sind.

4. Integrierte optoelektronische Vorrichtung (D) nach einem der Ansprüche 1 bis 3, wobei die Überschneidungszone (IIb) mit dem neu aufgebauten halbisolierenden Stapel (7) von der Basis (20) bis zur Oberseite der Schicht eines p-dotierten III-V-Halbleiters (4) gefüllt ist.

5. Integrierte optoelektronische Vorrichtung (D) nach einem der Ansprüche 1 bis 4, wobei die Endzone (IIc) mit dem neu aufgebauten halbisolierenden Stapel (7) von der Basis (20) bis zur Ebene der Oberseite der Schicht eines p-dotierten III-V-Halbleiters (4) gefüllt ist.

6. Integrierte optoelektronische Vorrichtung (D) nach einem der Ansprüche 1 bis 5, wobei der Metallstreifen (84), der den zweiten Streifenabschnitt (S2) abdeckt, sich auch über den halbisolierenden Stapel (7) der Endzone (IIc) erstreckt.

7. Integrierte optoelektronische Vorrichtung (D) nach einem der Ansprüche 1 bis 5, wobei die elektrische Trennung (9) ein Band von implantiertem H+ umfasst, das sich in der Überschneidungszone (IIb) zwischen den Seitenwänden (21, 22) senkrecht zur Längsachse (XX) befindet.

8. Verfahren zur Herstellung einer integrierten optoelektronischen Vorrichtung (D), wobei das Verfahren Folgendes umfasst:
A. Bereitstellen eines Substrats (1), das aus einem III-V-Halbleitermaterial mit einer Längsachse (XX) besteht;
B. Durchführen eines epitaxialen Aufbaus einer Schicht eines n-dotierten III-V-Halbleiters (2) auf dem Substrat (1);
C. selektives Ätzen der Schicht eines n-dotierten III-V-Halbleiters (2) hinunter bis zur Ebene des Substrats (1), um eine erste Nut (201) mit einem U-förmigen Querschnitt einer Breite W zu bilden, um eine Basis (20) und Seitenwände (21, 22) zu definieren;
D. Durchführen eines epitaxialen Aufbaus einer Schicht eines n-dotierten III-V-Halbleiters (2) und einem ersten aktiven Materialstapel (30'), um die erste Nut (201) auf der Schicht des neu aufgebauten n-dotierten III-V-Halbleiters (2) zu füllen;
E. Durchführen eines epitaxialen Aufbaus einer Schicht eines p-dotierten III-V-Halbleiters (4), um die erste Nut (201) auf dem ersten Materialstapel (30') mindestens bis zur Ebene der Oberseite der Seitenwände (21, 22) zu füllen;
F. Definieren von zwei verschiedenen Zonen entlang der Längsachse (XX) der integrierten optoelektronischen Vorrichtung (D), die eine erste Zone (I) und eine zweite Zone (II) umfassen;
G. in der zweiten Zone (II) selektives Ätzen der verschiedenen Stapel und Schichten, dadurch Füllen der ersten Nut (201) hinunter zum Boden der ersten Nut (201), um eine zweite Nut (202) mit einem U-förmigen Querschnitt von Breite W zu bilden;
H. in der zweiten Zone (II) Durchführen eines epitaxialen Aufbaus eines zweiten aktiven Materialstapels (31'), um die zweite Nut (202) auf der Schicht des n-dotierten III-V-Halbleiters (2) zu füllen, wobei der zweite aktive Materialstapel (31') mit dem ersten aktiven Materialstapel (30') in Linie ist;
I. in der zweiten Zone (II) Durchführen eines epitaxialen Aufbaus eines p-dotierten III-Halbleitermaterals (4), um die zweite Nut (202) auf dem zweiten Materialstapel (31') mindestens bis zur Ebene der Oberseite der Seitenwände (21, 22) zu füllen;
J. in der ersten Zone (I) Ätzen entlang der Längsachse (XX) mindestens unter der Ebene des ersten aktiven Materialstapels (30') eines ersten Paares von Längskanälen (C1, C2), von denen sich jeder entlang jeder Seitenwand (21, 22) befindet, um einen ersten zentralen Streifenabschnitt (S1) zu definieren, der den geätzten ersten aktiven Materialstapel (30'), der den optischen Lichtwellenleiter-Halbleiterverstärker (30) konstituiert, und die geätzte Schicht eines p-dotierten III-V Halbleitermaterials (4) umfasst, wobei die erste Zone (I) die Zone des optischen Halbleiterverstärkers konstituiert;
K. in der zweiten Zone (II) entlang der Längsachse (XX) mindestens unter der Ebene des zweiten aktiven Materialstapels (31') Ätzen eines Netzwerks von Nuten (C3, C4, C5, C6), die einen H-förmigen oberen Schnitt aufweisen und Folgendes umfassen:
**■** ein zweites Paar von Längskanälen (C3, C4), von denen sich jeder entlang jeder Seitenwand (21, 22) befindet, um einen zweiten zentralen Streifenabschnitt (S2) zu definieren, der den geätzten zweiten aktiven Materialstapel (31'), der den Lichtwellenleiter-PIN (31) konstituiert, und die geätzte Schicht eines p-dotierten III-V-Halbleitermaterials (4) umfasst, die alle zusammen die PIN-Zone (IIa) bilden,
**■** eine Übergangsnut (C5) mit einem U-förmigen Querschnitt einer Breite W, die sich zwischen der SOA-Zone (I) und der PIN-Zone (IIa) befindet und somit eine Überschneidungszone (IIb) bildet, wobei die Überschneidungsnut (C5) mit dem ersten (C1, C2) und dem zweiten (C3, C4) Paar von Längskanälen kommuniziert;
**■** eine Endnut (C6) mit einem U-förmigen Querschnitt einer Breite W, die sich am Ende der PIN-Zone (IIb) befindet, die gegenüber der SOA-Zone (I) liegt, und somit eine Endzone (IIc) bildet, wobei die Endnut (C6) mit dem zweiten Paar von Längskanälen (C3, C4) kommuniziert;
L. im ersten Paar von Längskanälen (C1, C2) und im Netzwerk von Nuten (C3, C4, C5, C6) Durchführen eines neuen Aufbaus eines halbisolierenden Stapels (7) mindestens bis zur Ebene der Oberseite der Schicht des p-dotierten III-V-Halbleitermaterials (4);
M. Auftragen von Metallstreifen (81, 82, 83) entlang der Längsachse (XX) auf der Oberseite der Seitenwände (21, 22) und auf der Oberseite des ersten und des zweiten zentralen Streifenabschnitts (S1, S2) wobei sich die Metallstreifen (84) im zweiten Streifenabschnitt (S2) befinden, der sich auf dem halbisolierenden Stapel (7) der Endzone (IIc) erstreckt;
N Bilden der elektrischen Trennung (9) zwischen der PIN-Zone (IIa) und der SOA-Zone (I) in der Überschneidungszone (IIb).

9. Verfahren zur Herstellung nach Anspruch 8, das ferner zwischen Schritt B und C einen Schritt B' zum Auftragen einer ersten dielektrischen Maske (61) auf die Schicht des n-dotierten III-V-Halbleiters (2) umfasst, um einen ersten maskierten Stapel (61') zu bilden, derart, dass das selektive Ätzen von Schritt C) aus dem Ätzen des ersten maskierten Stapels (61') besteht.

10. Verfahren zur Herstellung nach einem der Ansprüche 8 oder 9, wobei Schritt E und I den epitaxialen Aufbau von mindestens einer p-InP-Schicht (4a) und einer p-dotierten III-V-Halbleiterkontaktschicht (4b) zum Konstituieren der Schicht des p-dotierten III-V-Halbleiters (4) umfasst.

11. Verfahren zur Herstellung nach Anspruch 9, das ferner zwischen Schritt F und G einen Schritt F' zum Auftragen einer zweiten dielektrischen Maske (62) in der ersten Zone (I) zum Abdecken von mindestens der Schicht des p-dotierten III-V-Halbleiters (4) umfasst, um einen zweiten maskierten Stapel (62') zu bilden.

12. Verfahren zur Herstellung nach Anspruch 11, das ferner zwischen Schritt I und J einen Schritt I' zum Entfernen der verbleibenden Abschnitte der ersten und der zweiten dielektrischen Maske (61, 62) und zum Auftragen einer dritten dielektrischen Maske (63), die die obere Fläche der ersten und der zweiten Zone (I, II) abdeckt.

13. Verfahren zur Herstellung nach Anspruch 12, das ferner zwischen Schritt L und M einen Schritt L' zum Entfernen der verbleibenden Abschnitte der dritten dielektrischen Maske (63) umfasst.

14. Verfahren zur Herstellung nach einem der Ansprüche 8 bis 13, das zwischen Schritt L und M ferner einen Schritt L'' zur chemischen und/oder mechanischen Oberflächenabtragung des neu aufgebauten halbisolierenden Stapels (7) umfasst, um denselben auf die Ebene der Oberseite der Seitenwände (21, 22) abzuflachen.

15. Verfahren zur Herstellung nach einem der Ansprüche 8 bis 14, wobei Schritt N zum Bilden einer elektrischen Trennung (9) zwischen der PIN-Zone (IIa) und der SOA-Zone (I) in der Überschneidungszone (IIb) durch Implantieren von H+-Ionen in ein dünnes Band von implantiertem H+ realisiert wird, das sich zwischen den Seitenwänden (21, 22) und senkrecht zur Längsachse (XX) befindet.

## Revendications

1. Dispositif optoélectronique intégré (D) comprenant :
- un substrat (1) comprenant au moins un matériau semi-conducteur III-V,
**■** une couche d'un semi-conducteur III-V dopé n (2) disposée sur ledit substrat (1), ladite couche de semi-conducteur III-V dopé n (2) présentant une base (20) et deux parois latérales (21, 22) telles que ladite couche de semi-conducteur III-V dopé n (2) a une section transversale en forme de U ;
**■** dans une première zone (I) le long d'un axe longitudinal (XX) du dispositif optoélectronique intégré (D) :
∘ une première partie de bande centrale (S1) comprenant un amplificateur optique à semi-conducteur à guide d'onde optique (30) enterré, SOA,
∘ une première paire de canaux longitudinaux (C1, C2) situés chacun le long de chaque paroi latérale (21, 22) des deux côtés de la première partie de bande centrale (S1),
∘ ladite première zone (I) constituant la zone SOA, et la zone restante constituant la deuxième zone (II) ;
**■** dans ladite deuxième zone (II) le long dudit axe longitudinal (XX) :
∘ une zone de photodiode PIN (IIa) comprenant :
**■** une deuxième partie de bande centrale (S2) comprenant une photodiode PIN de guide d'onde optique (31) enterré, ladite photodiode PIN de guide d'onde optique (31) étant alignée avec l'amplificateur optique à semi-conducteur à guide d'onde optique (30) le long de l'axe longitudinal (XX) et étant au même niveau que la base (20),
**■** une deuxième paire de canaux longitudinaux (C3, C4) situés chacun le long de chaque paroi latérale (21, 22) des deux côtés de la deuxième partie de bande centrale (S2),
∘ une zone d'intersection (IIb) située entre la zone SOA (I) et la zone de photodiode PIN (IIa),
∘ une zone d'extrémité (IIc) située à l'extrémité de la zone de photodiode PIN (IIa) qui est opposée à la zone SOA (I),
**■** des bandes métalliques (81, 82) couvrant le haut des parois latérales (21, 22), et des bandes métalliques (83, 84) couvrant respectivement le haut des première et deuxième parties de bande centrale (S1, S2),
**■** une séparation électrique (9) entre la zone de photodiode PIN (IIa) et la zone SOA (I) entre les parois latérales (21, 22) perpendiculaire à axe longitudinal (XX) ;
dans lequel ledit amplificateur optique à semi-conducteur à guide d'onde optique (30) enterré de la première partie de bande centrale (S1) comprend au moins des multi puits quantiques ou points quantiques qui sont recouverts d'une couche d'un matériau à semi-conducteur III-V dopé p (4) comprenant au moins une couche p-InP (4a), et d'une couche de contact de semi-conducteur III-V dopé p (4b) au moins jusqu'au niveau du haut des parois latérales (21, 22) ;
dans lequel lesdits canaux longitudinaux (C1, C2) sont chacun remplis d'une pile semi-isolante (7) repoussée depuis la base (20) jusqu'au niveau du haut de la couche du matériau semi-conducteur III-V dopé p (4).

2. Dispositif optoélectronique intégré (D) selon la revendication 1, dans lequel ladite PIN de guide d'onde optique (31) enterré de la deuxième partie de bande centrale (S2) comprend au moins des multi puits quantiques ou points quantiques, qui sont recouverts d'une couche d'un semi-conducteur III-V dopé p (4) comprenant au moins une couche p-InP (4a), et d'une couche de contact de semi-conducteur III-V dopé p (4b) au moins jusqu'en haut des parois latérales (21, 22).

3. Dispositif optoélectronique intégré (D) selon l'une des revendications 1 et 2, dans lequel lesdits canaux longitudinaux (C3, C4) sont chacun remplis d'une pile semi-isolante (7) repoussée jusqu'en haut de la couche du semi-conducteur III-V dopé p (4).

4. Dispositif optoélectronique intégré (D) selon l'une des revendications 1 à 3, dans lequel ladite zone d'intersection (IIb) est remplie de la pile semi-isolante (7) repoussée depuis la base (20) jusqu'en haut de la couche du semi-conducteur III-V dopé p (4).

5. Dispositif optoélectronique intégré (D) selon l'une des revendications 1 à 4, dans lequel ladite zone d'extrémité (IIc) est remplie de la pile semi-isolante (7) repoussée depuis la base (20) jusqu'au niveau du haut de la couche du semi-conducteur III-V dopé p (4).

6. Dispositif optoélectronique intégré (D) selon l'une des revendications 1 à 5, dans lequel la bande métallique (84) couvrant la deuxième partie de bande (S2) s'étend également sur la pile semi-isolante (7) de la zone d'extrémité (IIc).

7. Dispositif optoélectronique intégré (D) selon l'une des revendications 1 à 5, dans lequel ladite séparation électrique (9) comprend un ruban de H+ implanté situé dans la zone d'intersection (IIb) entre les parois latérales (21, 22) perpendiculaire à l'axe longitudinal (XX).

8. Procédé de fabrication d'un dispositif optoélectronique intégré (D), ledit procédé comprenant les étapes suivantes :
A. fournir un substrat (1) réalisé en matériau semi-conducteur III-V ayant un axe longitudinal (XX) ;
B. effectuer une croissance épitaxiale d'une couche d'un semi-conducteur III-V dopé n (2) sur le substrat (1) ;
C. graver sélectivement ladite couche de semi-conducteur III-V dopé n (2) jusqu'au niveau dudit substrat (1) pour former une première rainure (201) avec une section transversale en forme de U d'une largeur W pour définir une base (20) et parois latérales (21, 22) ;
D. effectuer une croissance épitaxiale d'une couche d'un semi-conducteur III-V dopé n (2) d'une première pile de matériau actif (30') pour remplir la première rainure (201) sur la couche du semi-conducteur III-V dopé n (2) repoussé ;
E. effectuer une croissance épitaxiale d'une couche d'un semi-conducteur III-V dopé p (4) pour remplir ladite première rainure (201) sur la première pile de matériau actif (30') au moins jusqu'au niveau du haut des parois latérales (21, 22) ;
F. définir deux zones différentes le long de l'axe longitudinal (XX) du dispositif optoélectronique intégré (D), comprenant une première zone (I) et une deuxième zone (II) ;
G. dans la deuxième zone (II), graver sélectivement les différentes piles et couches remplissant la première rainure (201) jusqu'au fond de la première rainure (201), pour former une deuxième rainure (202) avec une section transversale en forme de U d'une largeur W ;
H. dans ladite deuxième zone (II), effectuer une croissance épitaxiale d'une deuxième pile de matériau actif (31') pour remplir ladite deuxième rainure (202) sur la couche du semi-conducteur III-V dopé n (2), ladite deuxième pile de matériau actif (31') étant alignée avec la première pile de matériau actif (30') ;
I. dans ladite deuxième zone (II), effectuer une croissance épitaxiale d'un matériau à semi-conducteur III-V dopé p (4) pour remplir ladite deuxième rainure (202) sur la deuxième pile de matériau actif (31') au moins jusqu'au niveau du haut des parois latérales (21, 22) ;
J. dans la première zone (I), le long de l'axe longitudinal (XX), au moins en dessous du niveau de la première pile de matériau actif (30'), graver une première paire de canaux longitudinaux (C1, C2) situés chacun le long de chaque paroi latérale (21, 22) de manière à définir une première partie de bande centrale (S1) comprenant la première pile de matériau actif (30') gravée constituant l'amplificateur optique à semi-conducteur à guide d'onde optique (30) et la couche du matériau semi-conducteur III-V dopé p(4) gravée, ladite première zone (I) constituant la zone d'amplificateur optique à semi-conducteur ;
K. dans la deuxième zone (II), graver le long de l'axe longitudinal (XX), au moins en dessous du niveau de la deuxième pile de matériau actif (31'), un réseau de rainures (C3, C4, C5, C6) ayant une découpe sur le haut en forme de H et comprenant :
**■** une deuxième paire de canaux longitudinaux (C3, C4), situés chacun le long de chaque paroi latérale (21, 22), pour définir une deuxième partie de bande centrale (S2) comprenant la deuxième pile de matériau actif (31') gravée constituant la PIN de guide d'onde optique (31) et la couche du matériau semi-conducteur III-V dopé p (4) gravée, le tout formant la zone PIN (IIa),
■ une rainure d'intersection (C5) avec une section transversale en forme de U d'une largeur W et étant située entre la zone SOA (I) et la zone PIN (IIa), formant ainsi une zone d'intersection (IIb), ladite rainure d'intersection (C5) communiquant avec la première paire de canaux longitudinaux (C1, C2) et la deuxième paire de canaux longitudinaux (C3, C4) ;
**■** une rainure d'extrémité (C6) avec une section transversale en forme de U d'une largeur W et étant située à l'extrémité de la zone PIN (IIb) qui est opposée à la zone SOA (I), formant ainsi une zone d'extrémité (IIc), ladite rainure d'extrémité (C6) communiquant avec la deuxième paire de canaux longitudinaux (C3, C4) ;
L. à l'intérieur de la première paire de canaux longitudinaux (C1, C2) et du réseau de rainures (C3, C4, C5, C6), effectuer la repousse d'une pile semi-isolante (7) au moins jusqu'au niveau du haut de la couche du matériau semi-conducteur III-V dopé p (4) ;
M. le long dudit axe longitudinal (XX), déposer des bandes métalliques (81, 82, 83) sur le haut des parois latérales (21, 22) et sur le haut des première et deuxième parties de bande centrale (S1, S2), la bande métallique (84) située sur la deuxième partie de bande (S2) s'étendant sur la pile semi-isolante (7) de la zone d'extrémité (IIc) ;
N. former une séparation électrique (9) entre la zone PIN (IIa) et la zone SOA (I) dans la zone d'intersection (IIb).

9. Procédé de fabrication selon la revendication 8, comprenant en outre une étape B' entre les étapes B et C, pour déposer un premier masque diélectrique (61) sur ladite couche de semi-conducteur III-V dopé n (2) afin de former une première pile masquée (61'), de sorte que la gravure sélective de l'étape C) consiste à graver la première pile masquée (61').

10. Procédé de fabrication selon l'une des revendications 8 ou 9, dans lequel les étapes E et I comprennent la croissance épitaxiale d'au moins une couche p-InP (4a) et d'une couche de contact de semi-conducteur III-V dopé p (4b) pour constituer la couche du semi-conducteur III-V dopé p (4).

11. Procédé de fabrication selon la revendication 9, comprenant en outre, une étape F' entre les étapes F et G, pour déposer un deuxième masque diélectrique (62) dans la première zone (I) afin de couvrir au moins la couche du semi-conducteur III-V dopé p (4) pour former une deuxième pile masquée (62').

12. Procédé de fabrication selon la revendication 11, comprenant en outre une étape I' entre les étapes I et J, pour retirer les parties restantes des premier et deuxième masques diélectriques (61, 62) et déposer un troisième masque diélectrique (63) couvrant la surface du haut des première et deuxième zones (I, II).

13. Procédé de fabrication selon la revendication 12, comprenant en outre une étape L' entre les étapes L et M, pour retirer les parties restantes du troisième masque diélectrique (63).

14. Procédé de fabrication selon l'une des revendications 8 à 13, comprenant en outre une étape L'' entre les étapes L et M, pour effectuer un décapage de surface chimique et/ou mécanique de la pile semi-isolante (7) repoussée afin de l'aplatir au niveau du haut des parois latérales (21, 22).

15. Procédé de fabrication selon l'une des revendications 8 à 14, dans lequel l'étape N pour former une séparation électrique (9) entre la zone PIN (IIa) et la zone SOA (I) dans la zone d'intersection (IIb) est réalisée par implantation d'ions H+ dans un mince ruban de H+ implanté situé entre les parois latérales (21, 22) et perpendiculaire à axe longitudinal (XX).
